Europäisches Patentamt

European Patent Office

Office européen des brevets

(11) Publication number: **0 454 917 B1**

# EUROPEAN PATENT SPECIFICATION

(45) Date of publication of patent specification: **17.08.94**  (51) Int. Cl.5: **H03L 7/23**

(21) Application number: **90304758.7**

(22) Date of filing: **02.05.90**

(54) **Frequency synthesiser.**

(43) Date of publication of application:
**06.11.91 Bulletin 91/45**

(45) Publication of the grant of the patent:
**17.08.94 Bulletin 94/33**

(84) Designated Contracting States:
**DE FR GB**

(56) References cited:
**EP-A- 0 278 140**
**EP-A- 0 338 742**
**GB-A- 2 055 519**
**GB-A- 2 099 645**

**RADIO & ELECTRON. Eng., vol. 48, no. 12;
December 1978, pages 593-602, London, GB.
W.A. Evans et al.: "A microprocessor-con-
trolled phase-locked signal source"**

(73) Proprietor: **Hewlett-Packard Limited
Cain Road
Bracknell, Berkshire RG12 1HN (GB)**

(72) Inventor: **Stockton, David
13 Dunvegan Court,
Crossford
Dunfermline, Fife, KY12 8YL Scotland (GB)**

(74) Representative: **Smith, Norman Ian et al
F.J. CLEVELAND & COMPANY
40-43 Chancery Lane
London WC2A 1JO (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to frequency synthesisers.

There are many applications in which there is a requirement for a frequency synthesiser capable of providing signals having a highly stable frequency which can be varied in finite steps over a specified range. There are several different types of frequency synthesiser which attempt to achieve this objective.

One known frequency synthesiser employs a phase-locked loop the reference signal for which is provided by a voltage controlled crystal oscillator. In the case of a digitally controlled phase locked loop the divider of the loop can be adjustable under microprocessor control to give range of frequencies at the output of the loop. Additionally the output of the crystal oscillator can be adjusted to provide additional output values between the coarse values provided by varying the division ratio of the loop. The resolution at the output of the loop can be improved by providing a further variable divider between the voltage controlled oscillator and the phase sensitive detector of the loop. Frequency synthesisers using phase locked loops can provide high frequency operation, but where fine resolution is required over the frequency range of the output this is difficult and expensive to achieve. An example of a frequency synthesiser which uses a phase-locked loop is described in EP-A-0278149. The phase locked loop includes an adjustable divider and the reference signal for the loop is applied to the loop by way of another adjustable divider. The reference signal is stabilised by a feedback arrangement which includes a counter and a D to A converter. The stabilising loop and the dividers are controlled by a microprocessor so that a wide range of frequencies can be generated by selection of the division ratios.

It is also known to generate signals by direct digital synthesis. Synthesisers using direct digital synthesis offer fine resolution, but the maximum frequency of their operation is limited. Their output has good phase noise, but quantisation distortion components are created. An example of direct digital synthesis is described in EP-A-0338747.

Attempts have been made to provide frequency synthesisers which make use of a combination of direct digital synthesis and phase locked loop techniques. One such synthesiser uses a direct digital synthesiser as the reference signal source for a phase locked loop frequency multiplier. A problem with such an arrangement is that the phase locked loop magnifies any quantisation components from the direct digital synthesiser which lie within its bandwidth. Additionally direct digital synthesisers are usually implemented in binary arithmetic and act as frequency multipliers where the multiplication factor is of the form $x/2^n$. This means that the step size resolution is the frequency of the input to the direct digital synthesiser divided by $2^n$. If n is not zero then $2^n$ is not a convenient decimal number. This makes it impossible to have a convenient round decimal value for both the input frequency to the direct digital synthesiser and the step size. This is inconvenient for users of frequency synthesisers.

The present invention is concerned with the frequency synthesiser which employs direct digital synthesis and phase locked loop techniques and which minimises the problems outlined above.

According to the present invention there is provided a frequency synthesiser comprising a frequency multiplier for providing the required output frequency, a reference frequency source coupled to a first direct digital synthesiser, said first direct digital synthesiser performing a multiplication of its input frequency by the factor $A/2^{na}$, A representing an integer value, and na representing the number of bits used in the synthesiser arithmetic, and

a reference loop

coupling the first direct digital synthesiser to the frequency multiplier, said reference loop including a second direct digital synthesiser performing a multiplication of its output frequency $B/2^{nb}$, B representing an integer value, and nb representing the number of bits used in the synthesiser arithmetic, wherein the two direct digital synthesisers operate in a reciprocal manner, and the na-values and nb-values in their multiplication factors can be made to cancel.

The invention will be described now by way of example only with particular reference to the accompanying drawings. In the drawings:

Figure 1 is a block schematic diagram of a frequency synthesiser in accordance with the present invention, and

Figure 2 is a block schematic diagram similar to Figure 1 but showing some of the elements in more detail.

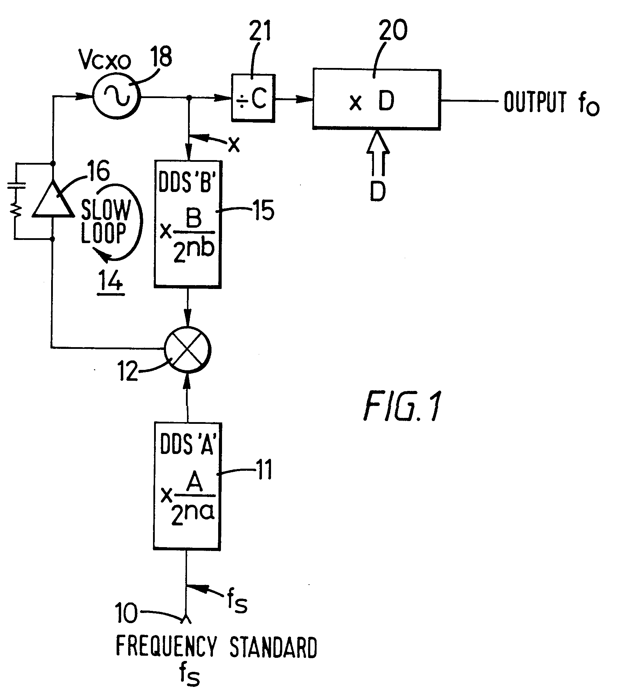

Referring to Figure 1 a frequency synthesiser comprises an input 10 to which is applied the output signal $f_s$ of a frequency standard. The input 10 is connected to a first direct digital synthesiser 11 which has a multiplication factor of $A/2^{na}$. A is an integer used to control the frequency output from the synthesiser and na is the number of bits used in the synthesiser arithmetic. The output of the synthesizer 11 is applied to the phase sensitive detector 12 of a reference loop 14. In addition to the phase sensitive detector 12 the loop 14 includes a second direct digital synthesiser 15 (shown as having a multiplication factor $B/2^{nb}$), an integrator 16 and a voltage controlled oscillator 18. The loop 14 provides a reference signal for a frequency multiplier 20, the reference signal being applied to the frequency multiplier 20 by way of a divider 21. The frequency multiplier 20 can be a phase locked loop. The output of the multiplier 20 is the required output frequency $f_o$.

Considering the operation of the circuit shown in Figure 1 the output of the direct digital synthesiser 11 is a signal of frequency

$$\frac{A}{2^{na}} \cdot f_s$$

The frequency of the signal at point x on Figure 1 is

$$\frac{2^{nb}}{B} \cdot \frac{A}{2^{na}} \cdot f_s.$$

The frequency of the signal at the output divider 21 is

$$\frac{A.2^{nb}. f_s}{C.B.2^{na}}$$

The frequency at the output of the multiplier 20 is given by

$$\frac{D.A.2^{nb}.f_s}{C.B.2^{na}}$$

Thus it can be seen that if the accumulator size of each of the direct digital synthesisers 11 amd 15 is made the same, i.e. na = nb, the factors $2^{na}$ and $2^{nb}$ cancel in the expression for $f_o$. Thus $f_o$ is given by

$$f_o = \frac{D.A.f_s}{C.B.}$$

This cancellation thus removes the usual problem of direct digital synthesisers, namely that of providing a convenient step size. With the arrangement described above it is possible to use a reference source having a round figure frequency value, e.g. 10 MHz. If B is made a fixed multiple of D then the effect of D on the step size contribution of the DDS system can be cancelled.

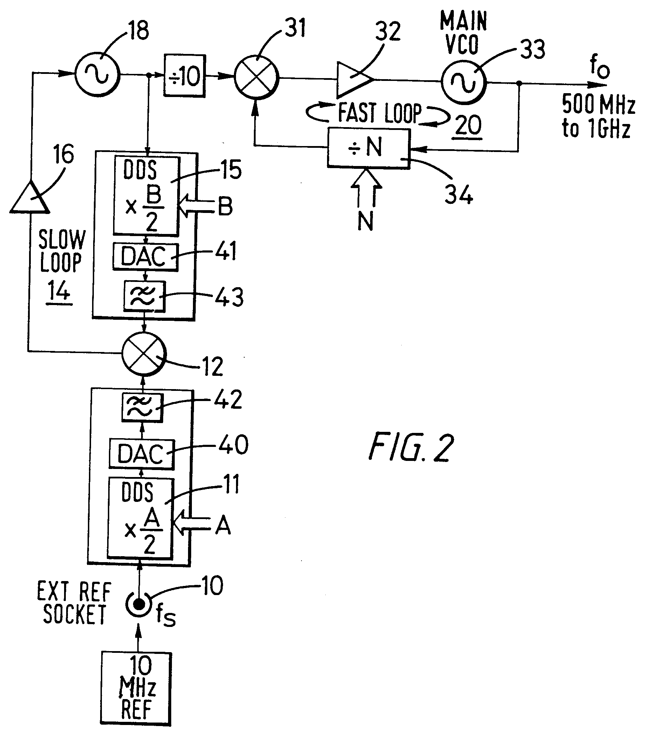

Referring to Figure 2 this shows in slightly more detail a frequency synthesiser of the general form shown in Figure 1. In this arrangement the output frequency mutliplier 20 comprises a phase locked loop having a phase sensitive detector 31, an integrator 32, a loop oscillator 33 and a divider 34. The division factor N of the divider can be adjusted.

As shown in Figure 2 each direct digital synthesiser has associated with it a digital to analoge converter 40, 41 and a low pass filter 42, 43. The oscillator 18 in the loop 14 is a crystal controlled oscillator whose output frequency can be varied slightly in a conventional manner.

It will be appreciated that an arrangement of the form shown in Figure 2 can be controlled by a conventional microprocessor to provide a desired output frequency.

By appropriate selection of parameters it is possible to simplify programming of such an arrangement. Consider the following example

Let $2^{na} = 2^{nb} = 2^{32} = 4,294,967,296$

Let $f_o = 10$ MHz

Let VCXO output frequency be 10 MHz ± 1000 ppm

Let $f_o$ cover 500-1000 MHz in 1Hz steps

Let C = 10

Let $A_{maximum} = B_{maximum} = 2^{30}$

Let N = 500-1000

Let B = N X 1,000,000 (so B = 500,000,000 to 1,000,000,000

and $2^{30} = 1,073,741,824$)

The output frequency $f_o$ is given

$$f_O = \frac{N.A.2^{nb}f_s}{C.B.2^{na}}$$

$$= \frac{N.A.2^{32}x10^7}{10.Dx10^6.2^{32}} \text{ Hz}$$

$$= A \text{ Hz}$$

Thus it can be seen by appropriate selection of the parameters in the expression for the output frequency, the output frequency is simply a function of the value loaded into the direct digital synthesiser 11. In the example given the phase sensitive detector 12 of the reference loop 14 runs at 1.25 to 2.5 MHz. This means that the two synthesisers 11 and 15 are in their optimum operating regions. In order to program such an arrangement all that is required is to carry out the following steps:

1. Select the nearest integer of the required output frequency expressed in MHz, load this as value N into the divider 34 of the phase locked loop 20.

2. Load 1,000,000 x N into the B section of the direct digital synthesiser 15.

3. Load the required frequency value in Hz into the A section of the digital synthesiser 11.

It will be appreciated that the above example applies for any output frequency $f_o$ in the range 500 MHz to 1000 MHz.

The synthesiser structure described above has a number of advantages. Firstly it enables the use of a frequency standard of a round decimal value (e.g. 10 MHz) as the frequency source applied to input 10 and still makes it possible to achieve round decimal (e.g. 1 Hz) step sizes in the output frequency even though the synthesiser uses binary arithmetic digital direct synthesisers. Secondly a constant step size is achieved across the output range without gaps. Thirdly the slow loop 14 acts as a narrow tracking filter effectively removing the quantising noise created by the use of direct digital synthesisers. The slow loop also removes any phase noise of the reference source thus eliminating the need for a separate clean-up loop which is usually required in conventional synthesisers making use of phase locked loops.

Additionally if required frequency modulation can be applied to the crystal controlled oscillator. Also digital to analogue converters can be used to pre-tune the crystal controlled oscillator 18 and the voltage controlled oscillator 33 in the phase locked loop thus speeding up lock acquisition.

It will be appreciated that where a sine wave output is required the output from the frequency multiplier is applied to a suitable filter structure.

**Claims**

1. A frequency synthesiser comprising a frequency multiplier (20) for providing the required output frequency ($f_o$), a reference frequency source ($f_s$) coupled to a first direct digital synthesiser, said first direct digital synthesiser (11) performing a multiplication of its input frequency by the factor $A/2^{na}$, A representing an integer value, and na representing the number of bits used in the synthesiser arithmetic, and

   a reference loop (14) coupling the first direct digital synthesiser (11) to the frequency multiplier (20), said reference loop (14) including

   a second direct digital synthesiser (15) performing a multiplication of its input frequency $B/2^{nb}$, B representing an integer value, and nb representing the number of bits used in the synthesiser arithmetic,

   wherein the two direct digital synthesisers (11, 15) operate in a reciprocal manner, and

the na-values and nb-values in their multiplication factors can be made to cancel.

2. A frequency synthesiser according to claim 1, wherein the frequency multiplier (20) is a phase locked loop.

3. A frequency synthesiser according to claim 2, wherein the phase locked loop includes a divider (34) whose division ratio can be varied.

4. A frequency synthesiser according to any preceding claim, wherein the multiplication factor of the second direct digital synthesiser (15) has a selected relationship with the multiplication factor of the frequency multiplier.

5. A frequency synthesiser according to claim 4, wherein the multiplication factors of the first and second direct digital synthesiser (11, 15) and the frequency multiplier (20) are selected such that the output frequency is directly related to multiplication factor of the first direct digital synthesiser (11).

6. A frequency synthesiser according to any preceding claim, wherein said reference loop (14) includes a voltage controlled crystal oscillator (18).

7. A frequency synthesiser according to any preceding claim, including a divider (21) coupling the reference loop (14) to the frequency multiplier (20).

8. A frequency synthesiser according to any preceding claim, including a microprocessor for adjusting the multiplication factors of the first and second direct digital synthesiser (11, 15) and the frequency multiplier (20) to provide the required output frequency.

**Patentansprüche**

1. Ein Frequenzsynthesizer, der folgende Merkmale einschließt:

   einen Frequenzmultiplizierer (20) zum Liefern der geforderten Ausgangsfrequenz ($f_o$), eine Referenzfrequenzquelle ($f_s$), die mit einem ersten direkten digitalen Synthesizer gekoppelt ist, wobei der erste direkte digitale Synthesizer (11) eine Multiplikation seiner Eingangsfrequenz mit dem Faktor $A/2^{na}$ durchführt, wobei A einen ganzzahligen Wert darstellt, und wobei na die Anzahl der Bits darstellt, die in der Synthesizerarithmetik verwendet ist, und eine Referenzschleife (14), die den ersten direkten digitalen Synthesizer (11) mit dem Frequenzmultiplizierer (20) koppelt, wobei die Referenzschleife (14) einen zweiten direkten digitalen Synthesizer (15) einschließt, der eine Multiplikation seiner Eingangsfrequenz mit $B/2^{nb}$ durchführt, wobei B einen ganzzahligen Wert darstellt, und nb die Anzahl von Bits darstellt, die in der Synthesizerarithmetik verwendet werden,

bei dem die zwei direkten digitalen Synthesizer (11, 15) in einer reziproken Art und Weise arbeiten, und

bei dem die na-Wert und nb-Werte in ihren Multiplikationsfaktoren so eingestellt werden können, daß sie sich kürzen.

2. Ein Frequenzsynthesizer gemäß Anspruch 1, bei dem der Frequenzmultiplizierer (20) eine Phasenregelschleife ist.

3. Ein Frequenzsynthesizer gemäß Anspruch 2, bei dem die Phasenregelschleife einen Teiler (34) einschließt, dessen Teilungsverhältnis variiert werden kann.

4. Ein Frequenzsynthesizer gemäß einem beliebigen vorhergehenden Anspruch, bei dem der Multiplikationsfaktor des zweiten direkten digitalen Synthesizers (15) eine ausgewählte Beziehung zu dem Multiplikationsfaktor des Frequenzmultiplizierers hat.

5. Ein Frequenzsynthesizer gemäß Anspruch 4, bei dem die Multiplikationsfaktoren des ersten und des zweiten direkten digitalen Synthesizers (11, 15) und der Frequenzmultiplizierer derart gewählt sind, daß die Ausgangsfrequenz direkt von dem Multiplikationsfaktor des ersten direkten digitalen Synthesizers (11) abhängt.

6. Ein Frequenzsynthesizer gemäß einem beliebigen vorhergehenden Anspruch, bei dem die Referenzschleife (14) einen spannungsgesteuerten Quarzoszillator (18) einschließt.

7. Ein Frequenzsynthesizer gemäß einem beliebigen vorhergehenden Anspruch, der einen Teiler (21), der die Referenzschleife (14) mit dem Frequenzmultiplizierer (20) koppelt, einschließt.

8. Ein Frequenzsynthesizer gemäß einem beliebigen vorhergehenden Anspruch, der einen Mikroprozessor zum Einstellen der Multiplikationsfaktoren des ersten und des zweiten direkten digitalen Synthesizers (11, 15) und des Frequenzmultiplizierers (20) einschließt, um die geforderte Ausgangsfrequenz zu liefern.

**Revendications**

1. Synthétiseur de fréquence comprenant un multiplicateur de fréquence (20) pour fournir la fréquence de sortie requise ($f_o$), une source de fréquence de référence ($f_s$) reliée à un premier synthétiseur numérique direct, ledit premier synthétiseur numérique direct (11) réalisant une multiplication de sa fréquence d'entrée par le facteur $A/2^{na}$, A représentant une valeur entière, et na représentant le nombre de bits utilisés dans l'arithmétique du synthétiseur, et

une boucle de référence (14) reliant le premier synthétiseur numérique direct (11) au multiplicateur de fréquence (20), ladite boucle de référence (14) comprenant

un second synthétiseur numérique direct (15) réalisant une multiplication de sa fréquence d'entrée par $B/2^{nb}$, B représentant une valeur entière, et nb représentant le nombre de bits utilisés dans l'arithmétique du synthétiseur,

dans lequel les deux synthétiseurs numériques directs (11, 15) fonctionnent d'une manière réciproque, et

les valeurs na et nb dans leurs facteurs de multiplication peuvent être éliminées.

2. Synthétiseur de fréquence selon la revendication 1, dans lequel le multiplicateur de fréquence (20) est une boucle à verrouillage de phase.

3. Synthétiseur de fréquence selon la revendication 2, dans lequel la bouche à verrouillage de phase comprend un diviseur (34) dont le rapport de division peut être modifié.

4. Synthétiseur de fréquence selon l'une quelconque des revendications précédentes, dans lequel le facteur de multiplication du second synthétiseur numérique direct (15) présente une relation sélectionnée avec le facteur de multiplication du multiplicateur de fréquence.

5. Synthétiseur de fréquence selon la revendication 4, dans lequel les facteurs de multiplication des premier et second synthétiseurs numériques directs (11, 15) et le multiplicateur de fréquence (20) sont sélectionnés de telle façon que la fréquence de sortie est directement reliée au facteur de multiplication du premier synthétiseur numérique direct (11).

6. Synthétiseur de fréquence selon l'une quelconque des revendications précédentes, dans lequel ladite boucle de référence (14) comprend un oscillateur à quartz commandé par tension (18).

7. Synthétiseur de fréquence selon l'une quelconque des revendications précédentes, comprenant un diviseur (21) reliant la boucle de référence (14) au multiplicateur de fréquence (20).

8. Synthétiseur de fréquence selon l'une quelconques des revendications précédentes, comprenant un microprocesseur pour régler les facteurs de multiplication des premier et second synthétiseurs numériques directs (11,15) et le multiplicateur de fréquence (20) afin de fournir la fréquence de sortie requise.

FIG.1

*FIG.2*